Europäisches Patentamt

European Patent Office

Office européen des brevets

(11) Numéro de publication: **0 248 737 B1**

# (12) FASCICULE DE BREVET EUROPEEN

(45) Date de publication de fascicule du brevet:
**29.01.92**

(51) Int. Cl.⁵: **G01R 29/10**

(21) Numéro de dépôt: **87401256.0**

(22) Date de dépôt: **04.06.87**

(54) **Circuit d'analyse d'un signal électrique modulé en amplitude, comprenant un transposeur de fréquence.**

(30) Priorité: **06.06.86 FR 8608204**

(43) Date de publication de la demande:
**09.12.87 Bulletin 87/50**

(45) Mention de la délivrance du brevet:
**29.01.92 Bulletin 92/05**

(84) Etats contractants désignés:
**DE GB NL SE**

(56) Documents cités:
**US-A- 3 300 722**
**US-A- 3 548 310**

(73) Titulaire: **ETABLISSEMENT PUBLIC DE DIFFU-SION dit "TELEDIFFUSION DE FRANCE"**
**10, rue d'Oradour sur Glane**
**F-75932 Paris Cédex 15(FR)**

Titulaire: **ETAT FRANCAIS représenté par le Ministre des PTT (Centre National d'Etudes des Télécommunications)**
**38-40 rue du Général Leclerc**
**F-92131 Issy-les-Moulineaux(FR)**

(72) Inventeur: **Piole, Philippe**
**51, Square Marcel Henri Lebouc**
**F-35700 Rennes(FR)**

(74) Mandataire: **Mongrédien, André et al**
**c/o BREVATOME 25, rue de Ponthieu**
**F-75008 Paris(FR)**

Rank Xerox (UK) Business Services

## Description

La présente invention a pour objet un circuit d'analyse d'un signal électrique modulé en amplitude, comprenant un transposeur de fréquence.

L'invention trouve de nombreuses applications, notamment dans la mesure de la distribution du courant le long d'une antenne par la méthode dite du rayonnement en retour modulé, dans la mesure du diagramme de rayonnement d'une antenne, et d'une façon plus générale dans les mesures en hyperfréquences (analyseur de réseaux, d'impédances, etc.).

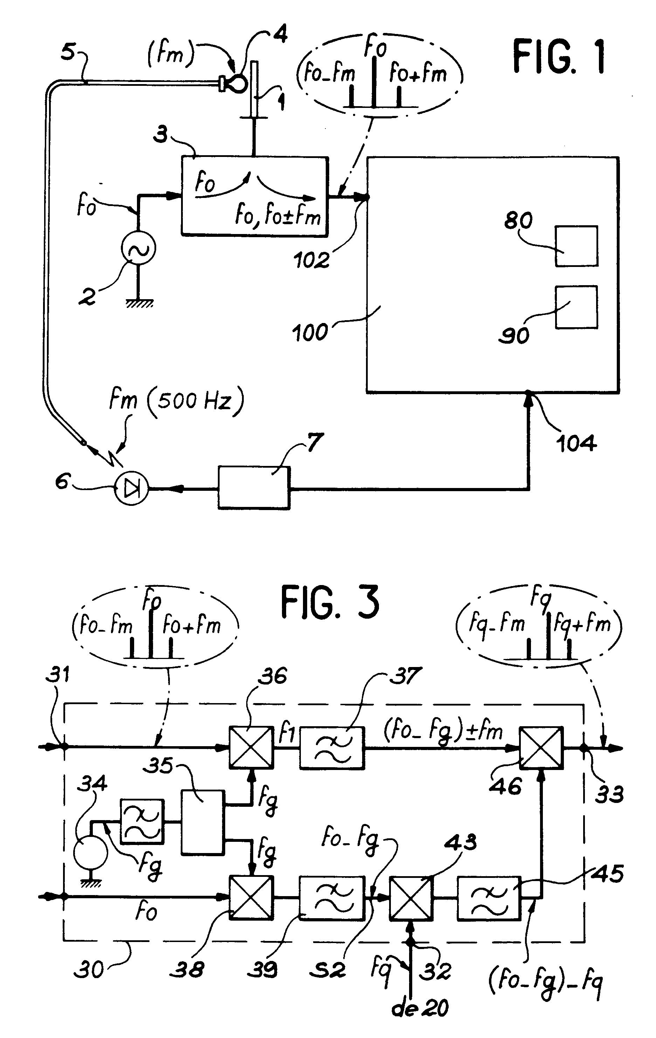

Pour exposer les principes de l'invention, on utilisera l'exemple de la mesure de la distribution du courant le long d'une antenne, par la méthode du rayonnement en retour modulé, sans que cet exemple soit en quoique ce soit limitatif pour la portée de l'invention. La figure 1 annexée illustre cette technique.

Une antenne 1 est alimentée par un générateur 2, à travers un circulateur (ou T hybride ou coupleur) référencé 3. Le générateur 2 travaille à une fréquence fo. Une petite sonde 4, formée d'une spire conductrice fermée sur une photorésistance, est déplacée le long de l'antenne. La photorésistance de la sonde est éclairée par un rayonnement lumineux guidé par une fibre optique 5 alimentée par une diode électroluminescente 6. Celle-ci est commandée par un circuit 7 comprenant un oscillateur travaillant à la fréquence fm. Le rayonnement lumineux modulé en amplitude, à la fréquence fm, provoque une variation de résistance de la photorésistance insérée dans la sonde. La sonde interagit avec l'antenne de sorte que le signal électrique réfléchi par l'antenne se trouve, lui aussi, modulé en amplitude à la fréquence fm.

Le signal délivré par le circuit 3 est donc de la forme $U(1 + m\cos w_m t)\cos(w_o t + \phi)$ où $U$ est une amplitude dont on peut montrer qu'elle est proportionnelle au carré du courant circulant dans l'antenne à l'endroit de la sonde, où $w_o$ est la pulsation $2\pi fo$, $\phi$ une phase où $m\cos w_m t$ caractérise la modulation d'amplitude à la pulsation $w_m = 2\pi fm$. Cette expression est valable à une tension parasite près, due aux fuites et aux désadaptations du système, tension qu'on négligera par la suite.

Le spectre d'un tel signal est formé d'une porteuse à la fréquence fo et de deux bandes latérales aux fréquences fo-fm et fo+fm. Un tel signal véhicule les informations d'amplitude et de phase relatives au courant circulant dans l'antenne au droit de la sonde.

Ce signal est analysé dans un circuit qui comprend entre autres

- une entrée générale recevant ce signal (S) modulé en amplitude,
- un oscillateur délivrant un signal,
- un circuit transposeur de fréquence possédant une première entrée reliée à l'entrée générale et une seconde entrée reliée à l'oscillateur et
- une voie de traitement apte à délivrer un signal fonction de la phase cette voie ayant une entrée auxiliaire pour l'introduction d'une partie du signal ayant servi à la modulation d'amplitude de la porteuse.

Le principe d'une telle méthode est décrite, par exemple, dans l'article de K. Iizuka intitulé "Photoconductive Probe For Measuring Electromagnetic Fields", publié dans Proceedings IEE, vol. 110, n°10, octobre 1963.

L'invention a pour objet un circuit qui est capable d'analyser un tel signal constitué d'une porteuse et de deux bandes latérales. Il porte la référence 100 sur la figure 1. Il comprend une entrée de signal 102 et une entrée auxiliaire 104 destinée à recevoir une parti du signal à la fréquence fm qui a servi moduler la diode. Le circuit de l'invention donne l'amplitude et la phase du courant circulant dans l'antenne, et, plus généralement, du signal haute fréquence ou en hyperfréquence qu'il faut analyser.

Pour traiter un tel signal, on utilise généralement, dans l'art antérieur, une technique de détection synchrone. Mais cette technique présente des inconvénients, notamment en ce qui concerne la difficulté d'obtenir un oscillateur local stable, et de réaliser une boucle à verrouillage de phase.

L'invention a pour but de remédier à ces inconvénients tout en procurant par ailleurs une grande finesse de bande d'analyse puisque celle-ci n'a que quelques Hertz de largeur. En outre, le circuit de l'invention est automatique, en ce sens qu'il ne nécessite pas de réglage extérieur, et ce dans une très large gamme de fréquence allant de 10 MHz à 2000 MHz et plus. Par ailleurs, la sensibilité du circuit de l'invention est supérieure à celle des circuits antérieurs d'environ 60 dB. Cette amélioration de la sensibilité permet de baisser le niveau du générateur de mesure (référencé 2 sur la figure 1), ce qui protège l'appareillage de mesure, tout en diminuant les perturbations vers l'extérieur.

Enfin, le circuit de l'invention constitue un circuit de base pour de multiples applications et pour des fréquences très diverses. En effet, si la fréquence du signal à traiter n'est pas dans la gamme pour laquelle le circuit a été conçu, il suffit d'effectuer une conversion de fréquence pour ramener celle-ci dans la gamme en question. C'est ainsi que des mesures à 12 GHz ont pu être effectuées avec succès.

Tous ces buts sont atteints par l'invention grâce à la mise en oeuvre d'un circuit de transposition de fréquence. A cette fin, un oscillateur à quartz à délivre un signal à une fréquence fq et un circuit transposeur de fréquence transforme le signal constitué par la porteuse à fo et deux bandes latérales à fo-fm et fo + fm en un signal à porteuse fq et à deux bandes latérales à fq-fm et fq + fm. Les valeurs de ces diverses fréquences sont en outre choisies pour que l'une de ces bandes latérales coïncide avec la fréquence centrale d'un filtre à quartz très étroit (de largeur 200 Hz par exemple). Ce filtre ne laisse alors subsister qu'une des bandes latérales, par exemple la bande inférieure à fq-fm. Le signal correspondant à cette bande transporte encore les informations relatives à l'amplitude et à la phase recherchées. Par une détection utilisant le signal à la fréquence fq émis par l'oscillateur à quartz, on restitue un signal à la fréquence fm d'où l'on peut extraire les informations d'amplitude et de phase en question.

Le fonctionnement du circuit est indépendant de la valeur de la fréquence porteuse fo, qui peut dès lors être comprise dans une plage large, allant par exemple de 2 à 2000 MHz.

A titre d'exemple, la fréquence fm peut être d'environ 500 Hz, la fréquence fq de 9000,5 kHz, ce qui met la bande latérale inférieure à fq-fm 9000 kHz : c'est la fréquence centrale du filtre. Celui-ci peut avoir une bande passante de 200 Hz. Après détection, un dernier filtrage peut avoir lieu à 500 Hz, avec une bande passant de 5 Hz. Si l'on part d'un oscillateur à quartz fonctionnant à 2 MHz avec un diviseur par 4096, on obtiendra pour fm une fréquence de 488 Hz.

De toute façon, les caractéristiques de l'invention apparaîtront mieux à la lumière de la description qui suit, d'exemples de réalisation donnés à titre explicatif et nullement limitatif. Cette description se réfère à des dessins annexés sur lesquels :

- la figure 1, déjà décrite, représente un exemple d'application du circuit de l'invention,
- la figure 2 montre le schéma synoptique du circuit de l'invention,
- la figure 3 représente un mode de réalisation d'un transposeur de fréquence,
- la figure 4 illustre un mode de réalisation des deux voies de traitement de l'amplitude et de la phase, dans le cas de la mesure du courant dans une antenne par la méthode du rayonnement en retour modulé,
- la figure 5 montre une autre application de l'invention, concernant le relevé du diagramme de rayonnement d'une antenne,
- la figure 6 montre une autre application concernant un analyseur vectoriel.

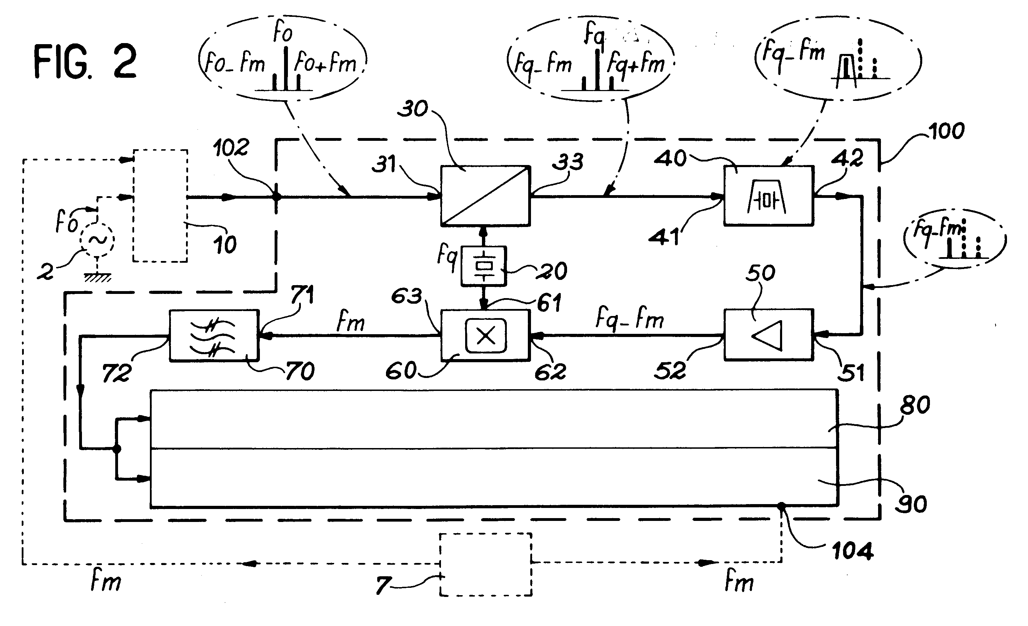

L'ensemble représenté sur la figure 2 comprend essentiellement le circuit 100 de l'invention. Ce circuit est alimenté par un système 10 qui n'est pas représenté en détail et qui peut être quelconque, sa fonction étant de recevoir un signal à la fréquence fo, (lequel est engendré par un générateur 2) et un signal à la fréquence fm, (lequel est engendré par un générateur 7). Dans le cas de l'application à la mesure du courant dans une antenne, et comme illustré déjà sur la figure 1, le circuit 10 sera constitué par un coupleur 3, une antenne 1 et une sonde 4. Mais d'autres dispositions sont possibles, comme on le verra plus loin, l'essentiel étant qu'on obtienne, en sortie du système 10, un signal constitué d'une porteuse à la fréquence fo avec deux bandes latérales à fo-fm et fo + fm. Ce signal est alors appliqué sur l'entrée 102 du circuit 100, pour traitement.

Tel que représenté, le circuit 100 comprend :
- une entrée générale 102 recevant le signal modulé en amplitude,
- un oscillateur à quartz 20 délivrant un signal à une fréquence fq,
- un circuit transposeur de fréquence 30 possédant une première entrée 31 reliée à l'entrée générale 102 et une seconde entrée 32 reliée à l'oscillateur 20 ; ce circuit délivre, sur une sortie 33, un signal correspondant à une porteuse à la fréquence fq avec deux bandes latérales aux fréquences fq-fm et fq + fm,
- un filtre à quartz du type passe-bande 40, centré sur la fréquence de l'une des bandes latérales fq-fm ou fq + fm, et de bande passante très étroite (par exemple 200 Hz) ; ce filtre coupe la porteuse fq et l'autre bande latérale ; 11 possède une entrée 41 reliée à la sortie du transposeur 30 et une sortie 42 délivrant la bande latérale filtrée, par exemple à la fréquence fq-fm,
- un amplificateur 50 ayant une entrée 51 reliée au filtre passe-bande 40 et une sortie 52 ; ce filtre possède par exemple un gain de 45 dB,
- un détecteur de produit 60 ayant une première entrée 61 reliée à l'oscillateur 20 et recevant un signal à la fréquence fq, une deuxième entrée 62 reliée à la sortie de l'amplificateur 50 et recevant un signal à la fréquence de la bande latérale filtrée (fq-fm dans l'exemple pris plus haut) ; ce détecteur possède une sortie 63 délivrant un signal à la fréquence fm,
- un filtre passe-bande 70 centré sur la fréquence fm (dans l'exemple cité, centré à 500 Hz) et de bande passante étroite de l'ordre de 5 Hz ; ce filtre possède une entrée 71 reliée à la sortie 63 du détecteur 60 et une sortie 72,
- une première voie de traitement 80 reliée à la sortie 72 du filtre passe-bande étroit 70 et apte à délivrer un signal fonction de l'amplitude du signal délivré par le filtre 70,
- une seconde voie de traitement 90 reliée à la sortie 72 du filtre passe-bande étroit 70 et apte à délivrer un signal fonction de la phase du signal délivré par le filtre 70, cette seconde voie ayant en outre une entrée auxiliaire 104 pour l'introduction d'une partie du signal de fréquence fm ayant servi à la modulation d'amplitude de la porteuse fo.

Le fonctionnement de ce circuit résulte clairement de ce qui a été dit plus haut : il y a transposition de fréquence sur fq puis filtrage d'une des bandes latérales et enfin restitution de la fréquence de modulation fm.

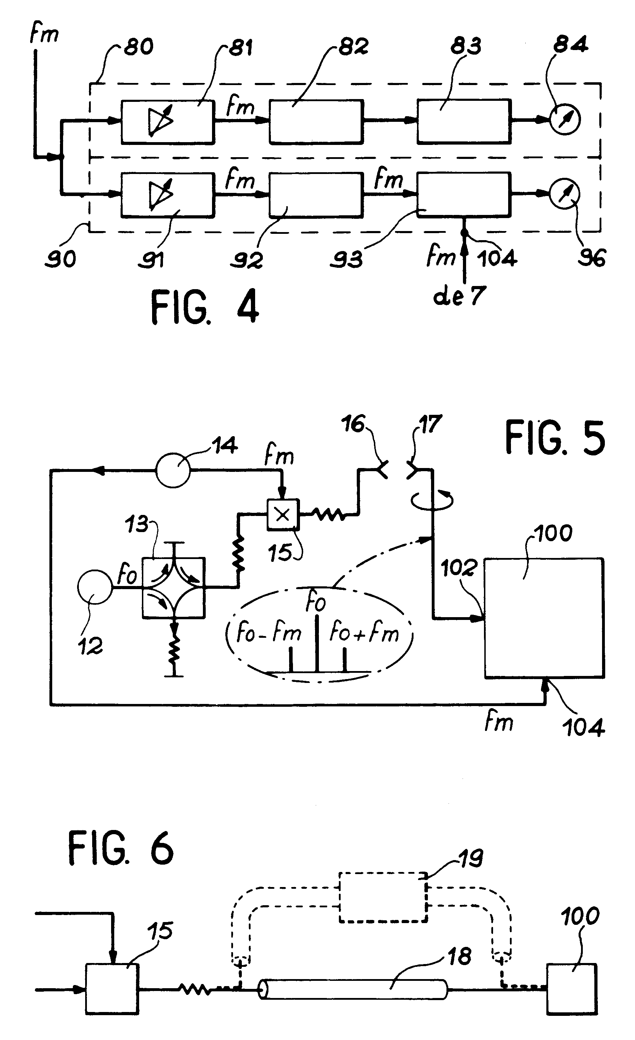

Des modes de réalisation des circuits 30, 80 et 90 sont illustrés sur les figures 3 et 4.

Le circuit représenté sur la figure 3, tout d'abord, correspond au transposeur de fréquence 30. Tel que représenté, il comprend :

- un oscillateur 34 délivrant un signal à une fréquence fg ; la valeur de fg diffère de la valeur fo d'une quantité inférieure à fq ; cela signifie, en pratique, que fg est compris entre fo-9MHz et fo+9MHz (si l'on a choisi fq à 9 MHz),
- un diviseur 35 à une entrée reliée à l'oscillateur 34 et à une première et une seconde sorties délivrant chacune des signaux à la fréquence fg,
- un premier mélangeur 36 à une première entrée reliée à l'entrée 31 du circuit transposeur et recevant le signal constitué de la porteuse à la fréquence fo et des deux bandes latérales à fo-fm et fo+fm et à une seconde entrée reliée à la première sortie du diviseur 35 et recevant un signal à la fréquence fg ; ce premier mélangeur possède une sortie qui délivre un signal ayant deux porteuses de fréquence égales à fo+fg et fo-fg et leurs bandes latérales,
- un premier filtre passe-bas 37 ayant une fréquence de coupure égale à fq et délivrant un premier signal filtré modulé en amplitude avec une porteuse à la fréquence fo-fg,
- un second mélangeur 38 ayant une première entrée recevant le signal à la fréquence fo et une seconde entrée reliée à la seconde sortie du diviseur 35 et recevant un signal à la fréquence fg ; ce second mélangeur délivre un signal à deux fréquences égales à fo+fg et fo-fg,
- un second filtre passe-bas 39 ayant une fréquence de coupure égale à fq, et délivrant un second signal filtré à la fréquence fo-fg,
- un troisième mélangeur 43 ayant une première entrée reliée au second filtre passe-bas 39 et recevant le second signal filtré à la fréquence fo-fg et une seconde entrée reliée à la seconde entrée 32 du circuit transposeur 30 et recevant le signal provenant de l'oscillateur à quartz 20 à la fréquence fq et une sortie délivrant un signal aux fréquences fq±-(fo-fg),

- un troisième filtre passe-bas 45 ayant une fréquence de coupure égale à fq, ce filtre étant relié au troisième mélangeur 43 et délivrant un troisième signal à la fréquence (fo-fg)-fq,
- un quatrième mélangeur 46 à une première entrée reliée au premier filtre passe-bas 37 et recevant le premier signal modulé en amplitude avec une porteuse à la fréquence fo-fg et une deuxième entrée reliée au troisième filtre passe-bas 45 et recevant le troisième signal à la fréquence (fo-fg)-fq et à une sortie 33 délivrant un signal constitué d'une porteuse à la fréquence fq et deux bandes latérales aux fréquences fq-fm et fq+fm.

Le fonctionnement du circuit de la figure 3 résulte de ce qui a été dit plus haut. Il s'agit, à l'aide d'un système à fréquence intermédiaire fg et grâce à des mélangeurs et des filtres, de transposer le signal incident qui contient la porteuse à fo et ses deux bandes latérales à fo-fm et fo+fm, sur un signal ayant une porteuse à fq et deux bandes latérales à fq-fm et fq+fm. Pour cela, on part du signal à la fréquence fo utilisé pour exciter l'antenne et on mélange ce signal avec un signal à une fréquence intermédiaire fg comprise entre fo-9MHz et fo+9MHz, la valeur 9MHz étant celle de la fréquence fq (à 0,0005MHz près). Mais cette valeur est arbitraire.

A la sortie des mélangeurs 36 et 38, on trouve un signal de mesure à la fréquence fo-fg compris entre 0 et 9MHz et un signal à la fréquence fo+fg que l'on élimine par les filtres passe-bas 37 et 39.

On trouve alors en sortie du filtre 37, à un terme près dû aux fuites et aux désadaptations, un signal de la forme :

$$S1 = U(1 + m\cos w_m t)\cos(w_1 t + \phi)$$

avec U : tension proportionnelle au carré du courant mesurer dans l'antenne, m : profondeur de modulation, $w_m$ : $2\pi fm$, $w_1$ $2\pi f_1$ où $f_1$ = fo-fg.

Le mélangeur 38 et le filtre 39 constituent une voie de référence qui délivre un signal à la fréquence $f_1$ = fo-fg.

Le mélangeur 43 reçoit ce signal avec le signal à la fréquence fq=9000,5 kHz. Le signal résultant possède un spectre à deux fréquences à $f_1 \pm fq$. Seul le battement inférieur est retenu par le filtre 45.

Le mélangeur double 46 combine ce dernier signal avec le signal filtré par 37. Les deux signaux ont une porteuse respectivement (fo-fg) et (fo-fg)-fq : il en résulte un battement à fq. Mais la première porteuse est associée à des bandes latérales distantes de ± fm. Finalement, on obtient donc une porteuse à fq avec deux bandes latérales à fq-fm et fq + fm.

Si fq est égal à 9000,5 kHz et fm à 0,5 kHz, la bande latérale inférieure se trouve à 9000 kHz, qui est la fréquence centrale du filtre (40 sur la figure 2). La bande latérale supérieure est de 9001 kHz. Comme le filtre 40 a une largeur de bande très faible, de l'ordre de 200 Hz, cette bande latérale supérieure tombe largement en dehors de la plage du filtre ainsi que la porteuse fq.

La figure 4 donne un mode de réalisation des voies 80 90 permettant d'extraire les informations d'amplitude et de phase. Les voies reçoivent le signal à la fréquence fm (500 Hz dans l'exemple pris), ce signal provenant de la sortie 72 du filtre 70 montré à la figure 2.

La voie 80 tout d'abord comprend un amplificateur 81, par exemple de 40 dB, puis un premier circuit analogique 82 qui donne la valeur efficace du signal et un second circuit analogique 83 qui extrait la racine carrée de la valeur efficace obtenue précédemment. Le résultat est affiché sur l'appareil de mesure 84 qui donne finalement l'amplitude du courant circulant dans l'antenne au droit de la sonde.

La voie 90 comprend d'abord un amplificateur 91, par exemple à contrôle automatique de gain (de l'ordre de 80 dB), un circuit de mise en forme 92 et un comparateur de phase 93. Ce circuit reçoit le signal à la fréquence fm provenant des circuits qui précèdent, mais aussi, par une entrée auxiliaire 104, le signal de référence, lui aussi à la fréquence fm et provenant de l'oscillateur 7 qui a servi à moduler la sonde. Ce comparateur délivre une information qui est affichée sur l'appareil 96. La calibration de l'appareil peut être telle qu'on affiche la demi-phase mesurée, car, dans la mesure du courant circulant dans une antenne, on peut montrer que la phase de ce courant est en fait la moitié de la phase obtenue après le circuit 93.

Dans tout ce qui précède, on a considéré, à titre d'exemple, que l'on filtrait la bande latérale inférieure située à fq-fm. Mais on peut tout aussi bien travailler avec la bande supérieure à fq + fm tout en conservant un filtre 40 fonctionnant à la même fréquence, c'est-à-dire 9000 kHz dans l'exemple pris. Pour cela, il suffit de prendre fq égal à 8999,5 kHz. La bande supérieure tombe alors exactement dans la bande du filtre.

La figure 5 montre un autre exemple de mise en oeuvre du circuit de l'invention. Il s'it de la mesure du diagramme de rayonnement d'une antenne. L'installation représentée comprend un générateur 12 travaillant à la fréquence fo, un coupleur adapté 13, un oscillateur 14 travaillant à la fréquence fm et un modulateur 15 qui permet d'alimenter l'antenne illuminante 16 par un signal à la fréquence fo modulé en amplitude par un signal à la fréquence fm. L'antenne à étudier 17 capte le champ électromagnétique rayonné par l'antenne 16. Le champ capté par l'antenne 17 en fonction de sa position angulaire définit le diagramme de rayonnement en amplitude et en phase. Le signal recueilli est constitué d'une porteuse à la fréquence fo et de deux bandes latérales à fo-fm et fo + fm. On retrouve donc le signal déjà considéré plus haut. Ce signal est appliqué à l'entrée 102 du circuit 100 de l'invention, lequel reçoit en outre, sur son entrée auxiliaire 104, un signal de référence à la fréquence fm provenant de l'oscillateur 14.

Dans cette application, il n'est plus besoin d'extraire la racine carrée de la valeur efficace pour obtenir l'amplitude recherchée, comme dans la mesure du courant dans une antenne. Dans la voie de traitement, le circuit 83 disparaît donc. De même, la phase obtenue n'est plus le double de la phase recherchée, comme dans l'application précédente, mais la phase elle-même. La calibration de l'appareil de mesure 96 est donc immédiate.

La sélectivité du circuit de l'invention étant très grande (de l'ordre de 5 Hz), on peut aisément s'affranchir des parasites présents éventuellement dans le champ d'antenne. Si un signal brouilleur se manifeste, il suffit de déplacer légèrement la fenêtre d'analyse, c'est-à-dire la fréquence d'émission, de quelques Hertz ou la fréquence fg. Le circuit de l'invention permet donc des mesures en milieu pollué, de l'amplitude et de la phase du rayonnement émis par une antenne.

Le circuit de l'invention peut servir également d'analyseur vectoriel. Sur la figure 6, l'antenne 16 et la sonde 17 sont remplacées par un câble 18 qui peut être d'abord relié directement au circuit 100 pour calibrage, puis à un quadripole 19 à tester, lequel a sa sortie reliée au circuit 100. Le circuit de l'invention se comporte alors comme un voltmètre vectoriel très sélectif et permet une analyse fine des caractéristiques d'un quadripole.

On peut aussi mesurer un coefficient de réflexion complexe provenant d'une impédance à tester.

On peut encore mesurer un courant circulant dans une antenne, mais au lieu de moduler le courant injecté dans l'antenne on module le courant prélevé par la sonde. Celle-ci n'est d'ailleurs pas forcément une boucle, mais peut être constituée par n'importe quel capteur (pointe, contact, capteur magnétique, électrique, etc.).

Divers circuits annexes peuvent être ajoutés aux circuits qui ont été décrits, notamment à ceux des figures 2 et 3. On peut utiliser un atténuateur calibré à l'entrée de la voie travaillant à 9 MHz. On peut aussi ajouter un convertisseur tension/fréquence après le détecteur de valeur efficace 82, pour fournir une indication sonore de l'amplitude, ce qui permet à l'opérateur de repérer aisément les ventres et les noeuds de courant le long de l'antenne. On peut aussi utiliser un coupleur et un détecteur à la sortie du circuit hybride 3 (fig. 1) pour surveiller le niveau de l'onde retour et éventuellement déclencher une alarme.

**Revendications**

1. Circuit d'analyse d'un signal électrique constitue par une porteuse de fréquence fo modulée en amplitude par un signal de fréquence fm, ce circuit (100) comprenant :
   - une entrée générale (102) recevant le signal (S) modulé en amplitude,
   - un oscillateur à quartz (20) délivrant un signal à une fréquence fq,
   - un circuit transposeur de fréquence (30) possédant une première entrée (31) reliée à l'entrée générale (102) et une seconde entrée (32) reliée à l'oscillateur (20) ; ce circuit transposeur de fréquence (30) délivre, sur une sortie (33), un signal correspondant à une porteuse à la fréquence fq avec deux bandes latérales aux fréquences fq-fm et fq+fm,
   - un filtre à quartz très étroit du type passe-bande (40), centré sur la fréquence de l'une des bandes latérales fq-fm ou fq+fm, et coupant la porteuse à la fréquence fq et l'autre bande latérale, ce filtre ayant une entrée (41) reliée à la sortie du circuit transposeur (30) et une sortie (42) délivrant la bande latérele filtrée,
   - un amplificateur (50) ayant une entrée (51) reliée au filtre passe-bande (40) et une sortie (52),
   - un détecteur de produit (60) ayant une première entrée (61) reliée l'oscillateur (20) et recevant un signal à la fréquence fq, une deuxième entrée (62) reliée à la sortie de l'amplificateur (50) et recevant un signal à la fréquence fq+fm ou fq-fm, ce détecteur (60) ayant une sortie (63) délivrant un signal à la fréquence fm,
   - un filtre passe-bande étroit (70) centré sur la fréquence fm, ayant une entrée (71) reliée à la sortie (63) du détecteur (60) et une sortie (72),
   - une première voie de traitement (80) reliée à la sortie (72) du filtre passe-bande étroit (70) et apte à délivrer un signal fonction de l'amplitude du signal délivré par le filtre passe-bande étroit (70),
   - une seconde voie de traitement (90) reliée à la sortie (72) du filtre passe-bande étroit (70) et apte à délivrer un signal fonction de la phase du signal délivré par le filtre passe-bande étroit (70), cette seconde voie ayant une entrée auxiliaire (104) pour l'introduction d'une partie du signal ayant servi à la modulation d'amplitude de la porteuse.

2. Circuit selon la revendication 1, caractérisé par le fait que le circuit transposeur de fréquence (30) comprend :
   - un oscillateur (34) délivrant un signal à une fréquence fg ; la valeur de fg différant de la valeur fo d'une quantité inférieure à fq,
   - un diviseur (35) à une entrée reliée à l'oscillateur (34) et à une première et une seconde sorties délivrant chacune des signaux à la fréquence fg,
   - un premier mélangeur (36) à une première entrée reliée à l'entrée (31) du circuit transposeur (30) et recevant le signal à la fréquence fo modulée en amplitude et à une seconde entrée reliée à la première sortie du diviseur (35) et recevant un signal à la fréquence fg ; ce premier mélangeur ayant une sortie,
   - un premier filtre passe-bas (37) ayant une fréquence de coupure égale à fq, ce filtre étant relié à la sortie du premier mélangeur et délivrant un premier signal filtré constitué par une porteuse à la fréquence fo-fg et ses bandes latérales,
   - un second mélangeur (38) ayant une première entrée recevant le signal à la fréquence fo et une seconde entrée reliée à la seconde sortie du diviseur (35) et recevant un signal à la fréquence fg et délivrant un signal à une fréquence égale à fo±fg,
   - un second filtre passe-bas (39) ayant une fréquence de coupure égale à fq, et délivrant un second signal filtré à la fréquence fo-fg,
   - un troisième mélangeur (43) ayant une première entrée reliée au second filtre passe-bas (39) et recevant le second signal filtré à la fréquence fo-fg et une seconde entrée reliée à la seconde entrée (32) du circuit transposeur et recevant le signal provenant de l'oscillateur à quartz (20) à la fréquence fq et une sortie délivrant un signal aux fréquences fq±(fo-fg),
   - un troisième filtre passe-bas (45) ayant une fréquence de coupure fq, et relié au troisième mélangeur (43) et délivrant un troisième signal (S3) à la fréquence (fo-fg)-fq,
   - un quatrième mélangeur (46) à une première entrée reliée au premier filtre passe-bas (37) et recevant la premier signal modulé en amplitude avec une porteuse à la fréquence fo-fg et une deuxième entrée reliée au troisième passe-bas (45) et recevant le troisième signal à la fréquence fq-(fo-fg) et à une sortie (33) délivrant un signal constitué d'une porteuse à la fréquence fq et deux bandes latérales aux fréquences fq-fm et fq + fm.

**Claims**

1. Circuit for analyzing an electric seal constituted a carrier of frequency formulated in amplitude by a frequency fm, said circuit comprising:
   a general input (102) receiving the amplitude-modulated signal (5);
   a quartz oscillator (20) supplying a signal at a frequency fq;
   a frequency transposing circuit (30) having a first input (31) connected to the general input (102) and a second input (32) connected to the oscillator (20), said frequency transposing circuit (30) supplying to an output (33) a signal corresponding to a carrier at frequency fq with two side bands at frequencies fq-fm and fq + fm;
   a very narrow band pass-type crystal filter (40) centred on the frequency of one of the side bands fq-fm or fq + fm and cutting the carrier at frequency fq and the other side band, said filter having an input (41) connected to the output of the transposing circuit (30) and an output (42) supplying the filtered side band;
   an amplifier (50) having an input (51) connected to the band pass filter (40) and an output (52);
   a product detector (60) having a first input (61) connected to the oscillator (20) and receiving a signal at frequency fq, a second input (62) connected to the output of the amplifier (50) and receiving a signal at frequency fq + fm or fq-fm, said detector (60) having an output (63) supplying a signal at frequency fm;
   a narrow band pass filter (70) centred on frequency fm having an input (71) connected to the output (63) of the detector (60) and an output (72);
   a first processing channel (80) connected to the output (72) of the narrow band pass filter (70) and able to supply a signal which is a function of the amplitude of the signal supplied by the narrow band pass filter (70);
   a second processing channel (90) connected to the output (72) of the narrow band pass filter (70) and able to supply a signal which is a function of the phase of the signal supplied by the narrow band pass filter (70), said second channel having an auxiliary input (104) for the introduction of part of the signal which has been used for the amplitude modulation of the carrier.

2. Circuit according to claim 1, characterized in that the frequency transposing circuit (30) comprises:
   an oscillator (34) supplying a signal at a frequency fg, the value of fg differing from the value fo by a quantity less than fq;
   a divider (35) having an input connected to the oscillator (34) and first and second outputs each supplying signals at frequency fg;
   a first mixer (36) having a first input connected to the input (31) of the transposing circuit (30) and receiving the signal at frequency fo modulated in amplitude and a second input connected to the first output of the divider (35) and receiving a signal at frequency fg, said first mixer having an output;
   a first low pass filter (37) having a cut-off frequency equal to fq, said filter being connected to the output of the first mixer and supplying a first filtered signal constituted by a carrier at frequency fo-fg and its side bands;
   a second mixer (38) having a first input receiving the signal at frequency fo and a second input connected to the second output of the divider (35) and receiving a signal at frequency fg and supplying a signal at a frequency equal to fo±fg;
   a second low pass filter (39) having a cut-off frequency equal to fq and supplying a second signal filtered at frequency fo-fg;
   a third mixer (43) having a first input connected to the second low pass filter (39) and receiving the second signal filtered at frequency fo-fg and a second input connected to the second input (32) of the transposing circuit and receiving the signal from the quartz oscillator (20) at frequency fg and an output supplying a signal at frequencies fq±(fo-fg);
   a third low pass filter (45) having a cut-off frequency fq and connected to the third mixer (43) and supplying a third signal (53) at frequency (fo-fg) fq;
   a fourth mixer (46) with a first input connected to the first low pass filter (37) and receiving the first amplitude-modulated signal with a carrier at frequency fo-fg and a second input connected to the third low pass filter (45) and receiving the third signal at frequency fq-(fo-fg) and an output (33) supplying a signal constituted by a carrier at frequency fq and the two side bands at frequencies fq-fm and fq + fm.

## Patentansprüche

1. Schaltung zum Analysieren eines elektrischen Signals, das von einem Träger der Frequenz fo gebildet ist, der mit einem Signal der Frequenz fm amplitudenmoduliert ist, wobei diese Schaltung (100) enthält:

    einen allgemeinen Eingang (102), der das amplitudenmodulierte Signal S aufnimmt,

    einen Querzoszillator (20), der ein Signal der Frequenz fq abgibt,

    eine Frequenzwandlerschaltung (30) mit einem ersten Eingang (31), der zwischen den allgemeinen Eingang (102) und einen zweiten Eingang (32) geschaltet ist, an den ein Oszillator (20) angeschlossen ist; wobei diese Frequenzwandlerschaltung (30) an einem Ausgang (33) ein Signal abgibt, das einem Träger der Frequenz fq mit zwei Seitenbändern mit Frequenzen fq - fm und fq + fm entspricht,

    ein sehr schmales Bandpaß-Quarzfilter (40), das auf die Frequenz eines der Seitenbänder fq - fm oder fq + fm abgestimmt ist und den Träger der Frequenz fq und das andere Seitenband abschneidet und das einen Eingang (41) aufweist, der mit dem Ausgang der Wandlerschaltung (30) verbunden ist, und einen Ausgang (42) hat, der das gefilterte Seitenband abgibt,

    einen Verstärker (50) mit einem Eingang (51), der mit dem Bandpaßfilter (40) verbunden ist, und einem Ausgang (52),

    einen Produktdetektor (60) mit einem ersten Eingang (61), der mit dem Oszillator (20) verbunden ist und ein Signal der Frequenz fq aufnimmt, einem zweiten Eingang (62), der mit dem Ausgang des Verstärkers (50) verbunden ist und ein Signal der Frequenz fq + fm oder fq - fm aufnimmt, wobei dieser Detektor (60) einen Ausgang (63) aufweist, der ein Signal der Frequenz fm abgibt,

    ein schmales Bandpaßfilter (70), das auf die Frequenz fm abgestimmt ist, mit einem Eingang (71), der mit dem Ausgang (63) des Detektors (60) verbunden ist und einem Ausgang (72),

    einen ersten Verarbeitungskanal (80), der mit dem Ausgang (72) des schmalen Bandpaßfilters (70) verbunden ist und dazu dient, ein Signal in Abhängigkeit von der Amplitude des durch da schmale Bandpaßfilter (70) abgegebenen Signals abzugeben,

einen zweiten Verarbeitungskanal (90), der mit dem Ausgang (72) des schmalen Bandpaßfilters (70) verbunden ist und dazu dient, ein Signal in Abhängigkeit von der Phase des von dem schmalen Bandpaßfilter (70) abgegebenen Signals zu liefern, wobei dieser zweite Kanal einen Hilfseingang (104) für die Zuführung eines Teils des Signals aufweist, das zur Amplitudenmodulation des Trägers gedient hat.

2. Schaltung nach Anspruch 1, dadurch gekennzeichnet, daß die Frequenzwandlerschaltung (30) enthält:

    einen Oszillator (34), der ein Signal der Frequenz fg abgibt; wobei die Größe von fg von der Größe fo um einen Betrag kleiner als fq abweicht,

    einen Teiler (35) mit einem Eingang, der mit dem Oszillator (34) verbunden ist, und ersten und zweiten Ausgängen, die jeweils Signale der Frequenz fg abgeben,

    einen ersten Mischer (36) mit einem ersten Eingang, der mit dem Eingang (31) der Wandlerschaltung (30) verbunden ist und das amplitudenmodulierte Signal der Frequenz fo aufnimmt, und einem zweiten Eingang, der mit dem ersten Ausgang des Teilers (35) verbunden ist und ein Signal der Frequenz fg aufnimmt; wobei dieser erste Mischer einen Ausgang aufweist,

    ein erstes Tiefpaßfilter (37) mit einer Grenzfrequenz von fq, das mit dem Ausgang des ersten Mischers verbunden ist und ein erstes gefiltertes Signal abgibt, das von einem Träger der Frequenz fo - fg und seinen Seitenbändern gebildet ist,

    einen zweiten Mischer (38) mit einem ersten Eingang, der das Signal der Frequenz fo aufnimmt, und einem zweiten Eingang, der mit dem zweiten Ausgang des Teilers (35) verbunden ist und ein Signal der Frequenz fg aufnimmt und der ein Signal der Frequenz fo ± fg abgibt,

    ein zweites Tiefpaßfilter (39) mit einer Grenzfrequenz von fq, das ein zweites gefiltertes Signal der Frequenz fo - fg abgibt,

einen dritten Mischer (43) mit einem ersten Eingang, der mit dem zweiten Tiefpaßfilter (39) verbunden ist und das zweite gefilterte Signal der Frequenz fo - fg entgegennimmt, und mit einem zweiten Eingang, der mit dem zweiten Eingang (32) der Wandlerschaltung verbunden ist und das von dem Quarzoszillator (20) der Frequenz fq stammende Signal entgegennimmt, und mit einem Ausgang, der ein Signal der Frequenzen fq ± (fo-fg) abgibt,

ein drittes Tiefpaßfilter (45) mit einer Grenzfrequenz fq, das mit dem dritten Mischer (439 verbunden ist und ein drittes Signal 53 der Frequenz (fo-fg) - fq abgibt,

einen vierten Mischer (46) mit einem ersten Eingang, der mit dem ersten Tiefpaßfilter (37) verbunden ist und das erste amplitudenmodulierte Signal mit einer Trägerfrequenz von fo - fg entgegennimmt, und mit einem zweiten Eingang, der mit dem dritten Tiefpaßfilter (45) verbunden ist und das dritte Signal der Frequenz fq - (fo-fg) entgegennimmt, und mit einem Ausgang (33), der ein Signal abgibt, das aus einem Träger der Frequenz fq und zwei Seitenbändern der Frequenzen fq - fm und fq + fm besteht.

EP 0 248 737 B1

FIG. 1

FIG. 3

FIG. 2

FIG. 4

FIG. 5

FIG. 6